# EUROPEAN PATENT APPLICATION

(11) **EP 0 684 707 A1**
(43) Date of publication of application: **29.11.1995**
(21) Application number: 95303546.6
(22) Date of filing: 25.05.1995
(51) Int. Cl.: H04B 7/005

(54) **Antenne array for a cellular radio base station with transmission power control**

(30) Priority: 28.05.1994 GB 9410809; 28.11.1994 GB 9424122
(71) Applicant: NORTHERN TELECOM LIMITED, Montreal, Quebec H2Y 3Y4 (CA)
(72) Inventor: Chrystie, Peter John, Brixham, TQ5 0NQ Devon (GB); Fisher, Clement Frederick, Totnes, TQ9 6SX Devon (GB)
(74) Representative: Ryan, John Peter William

(57) **Abstract**

A cellular radio base station arrangement has a plurality of r.f. transceivers (60,61) each for transmitting and receiving r.f. signals to and from antenna arrays (20,22,24) via respective transmit and receive paths for one or more calls. The arrangement includes means (70) for monitoring the power level at the antennas. A digital feedback link transfers the detected antenna transmit power levels to the r.f. transceivers where adjustment means vary the power levels fed to the antennas to maintain the antenna output within maximum permitted levels.

## Description

This invention relates to a base station arrangement, for use in a cellular radio communications system.

Cellular radio systems are currently in widespread use throughout the world providing telecommunications to mobile users. In order to meet the capacity demand, within the available frequency band allocation, cellular radio systems divide a geographic area to be covered into cells. At the centre of each cell is a base station through which the mobile stations communicate with each other and with a fixed (wired) network. The available communication channels are divided between the cells such that the same group of channels are reused by certain cells. The distance between the reused cells is planned such that co-channel interference is maintained at a tolerable level.

When a new cellular radio system is initially deployed operators are often interested in maximising the uplink (mobile station to base station) and downlink (base station to mobile station) range. Any increase in range means that less cells are required to cover a given geographic area, hence reducing the number of base stations and associated infrastructure costs. The downlink range is primarily increased by increasing the radiated power from the base station. National regulations, which vary from country to country, set a maximum limit on the amount of effective isotropic radiated power (EIRP) which may be emitted from a particular type of antenna being used for a particular application. In Great Britain, for example, the EIRP limit for digital cellular systems is currently set at +56dBm. Hence the operator is constrained and, in order to gain the maximum range allowable, must operate as close as possible to the EIRP limit, without exceeding it.

Sectored cells with multiple (usually 3 or 6) directional antennas are used as a means of extending the range whilst maintaining a balanced link. The higher gain of the narrower beamwidth antennas improves the uplink from the lower power mobiles, as well as the downlink.

One characteristic of communications systems employing radio links is that a signal operating at a particular frequency may be in a fade whilst another signal operating at a different frequency between the same transmit and receive path is transmitted without such a problem. Accordingly it is known to change frequency or 'frequency hop' during a radar transmission.

Frequency hopping is a standard feature of some communications systems such as GSM. When a mobile is in a "fade", if you change frequency it would almost certainly not then be in a fade. It should be noted that fading can be extremely localised. For instance if one encounters a fade, one would probably come out of a fade into a non-fade area for a particular frequency by movement of the mobile by just a few centimetres. So its overall purpose is to maintain the quality of near-stationary mobiles.

Frequency hopping also provides some advantages against interference. The frequency hopping is continuous i.e. it happens all the time, and it is not just when a fade is detected that it comes into operation.

According to the present invention there is provided a cellular radio base station comprising a plurality of r.f. transceivers each for transmitting and receiving r.f. signals to and from an antenna array via respective transmit and receive paths for one or more calls, wherein each array comprises individual transmit attenuation means and amplifying means for each call, power detecting means located proximate to the antenna, and digital feedback means for controlling the attenuation means responsive to the detected output power.

According to a further aspect of the invention the base station arrangement is operable on a frequency hopping basis with the frequency band divided into a number of sub-bands, wherein the amplifiers of the base station amplify the output as a function of frequency sub-band.

According to another aspect of the invention there is provided an antenna arrangement wherein the attenuation is varied as a function of frequency.

According to another aspect of the invention, in a cellular radio base station arrangement comprising a plurality of r.f. transceivers each for transmitting and receiving r.f. signals to and from an antenna array via respective transmit and receive paths for one or more calls, wherein each array comprises individual transmit amplifying means for each call, power detecting means located proximate the antenna, and digital feedback means for controlling the amplification responsive to the detected output power, there is provided a method of operating a cellular radio base station comprising the steps of:
transmitting radio signals at a particular radio frequency for each call;
monitoring the output power of the signal via the power level sensing means; and
varying the power level fed to the antenna responsive to the power level sensing means.

Preferably the frequency band is divided into sub-bands and the input signal provided for amplification is attenuated by a given factor dependent upon the frequency sub-band of operation.

In accordance with another aspect of the invention there is provided, in a frequency hopping base station arrangement, a method of operation comprising the steps of:
i) transmitting a radio signal at a particular frequency by a transmitter operable to feed an antenna,
ii) monitoring the output power level of the signal via power level sensing means;
iii) transmitting data digitally from the power level sensing means to transmitter control means;
iv) varying the power level fed to the antenna responsive to the power level sensing means; and
v) changing the operating frequency of the call and monitoring the output power level as in steps ii) through to iv) until the frequency is changed and the process is repeated.

Preferably a further step of dividing the frequency operating band of the base station into a number of frequency sub-bands and varying the power level fed to the amplification means responsive to frequency sub-band is included.

Embodiments of the invention will now be described with reference to the accompanying drawings, in which:-
Fig. 1 is a block diagram of the main elements of a base station;
Fig. 2 is a diagram of the constituents of a base station incorporating a floating transceiver;
Fig. 3 is a detailed diagram of the constituents of the automatic level control circuitry.

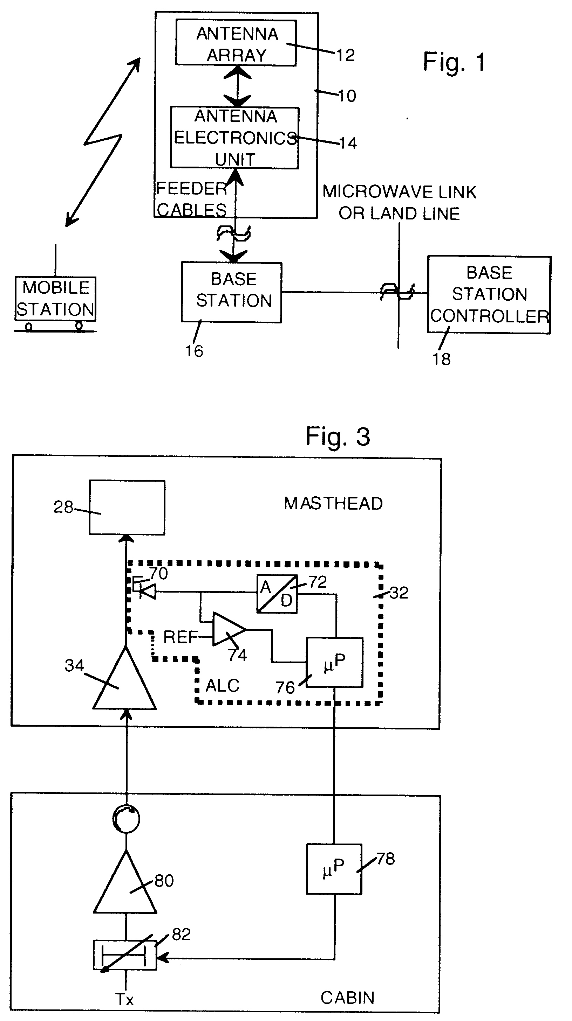

The main elements of a base station as shown in Fig. 1 comprise a mast, tower or building 10 supporting the antenna array(s) 12 and associated antenna electronics unit 14, which includes beamformers, diplexers and amplifiers. The antenna electronics unit 14 (the masthead electronics) is connected to the base station 16 that is under the control of a base station controller 18 which may be located remotely from the base station.

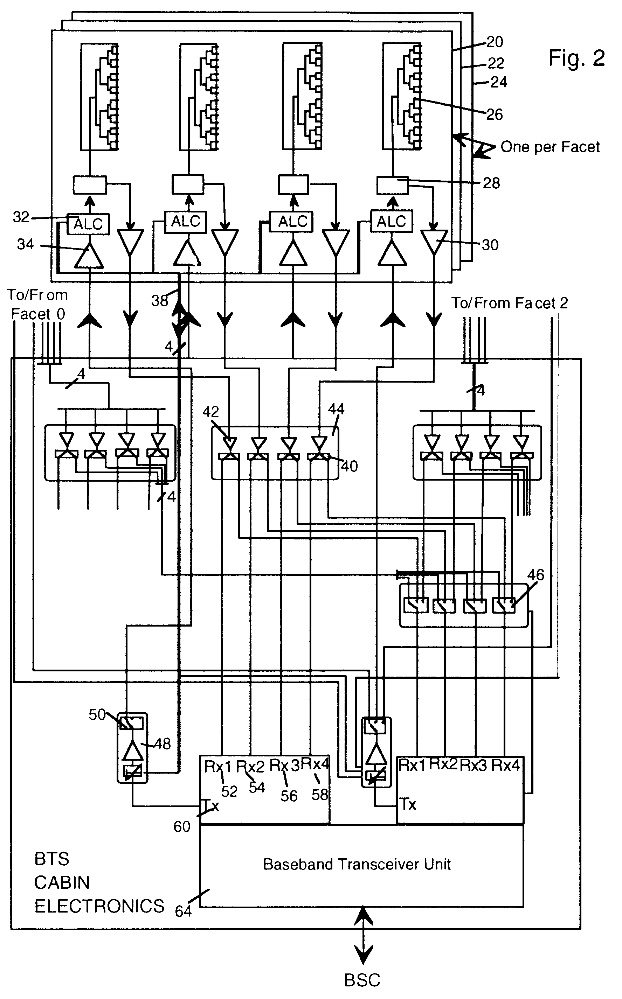

The detailed constituents of the antenna are shown in Fig. 2. The antenna shown is of the arrangement wherein there are provided a plurality of r.f. transceivers each for transmitting and receiving r.f. signals to and from the antenna via respective transmit and receive paths for one or more calls. The arrangement includes one or more antenna arrays wherein each array comprises a plurality of sub-arrays each capable of forming a beam in azimuth, elevation beamforming means for each sub-array and individual transmit and receive amplifying means for each sub-array. Each sub-array beamforming means is coupled to at least one r.f. transmitter feed means and each r.f. receiver feed means is coupled to at least two sub-array beamforming means. The sub-arrays of each antenna array together are capable of forming a multiplicity of separate substantially coincident beams in azimuth. Such an antenna is disclosed in the applicant's co-pending application 9402942.8. For clarity only one of the three antenna arrays 20, 22 and 24 and two of the r.f. transceivers, one 'fixed' transceiver 60 and one 'floating' transceiver 61, are depicted. The use of a floating transceiver is optional and of course is shown only by way of example. Each antenna array 20, 22, 24 comprises multiple sub-arrays 26 with each sub-array comprising a conventional column of individual antenna elements.

The transmit and receive signals for each sub-array are coupled to the sub-array via diplexers 28. Filters that cover just the transmit or receive frequency bands respectively can be used for this purpose. In the transmit path the diplexers 28 are fed, via an automatic level control (ALC) circuit 32, from single carrier power amplifiers 34. These amplify the r.f. signals up to the power levels required for transmission.

The automatic level control circuit for a single transmit path is shown in greater detail in Fig. 3. The ALC circuit 32 as shown comprises a power sensing element 70 that feeds an analogue-to-digital (A/D) converter 72 and a comparator 74. The comparator is used to detect the presence of a signal during a timeslot and is used to trigger a sequence of events within the microprocessor 76. The microprocessor accepts a reading from the A/D converter and in the following timeslot transmits this data down a digital serial link to an associated microprocessor 78 in the cabin. The cabin microprocessor 78 in turn controls a variable attenuator 82 that has a range sufficient to cope with expected variations in mast height together with fluctuations due to temperature, loading, etc. In the transmit path the signal is fed from the transmitter 60 via the attenuator 82, through a preamplifier 80 and then through one path of a 3 way switch 50, prior to reaching the masthead where it is amplified to its final level by the single carrier power amplifier 34. The use of a digital feedback arrangement enables a rapid change of power from one timeslot to another and adjustments can be performed with minimal phase lag. Furthermore this enables the power level at the masthead to be accurately determined whilst the cabin may be situated at a distance away from the antenna whereby the control electronics are easily available for service and repair.

Referring again to Fig. 2, in the receive path the diplexers 28 feed separate substantially identical low noise amplifiers 30. The low noise amplifiers are required to amplify the weak received r.f. signals prior to any system losses to establish a low noise figure (high sensitivity) in the subsequent receive path. Signals are passed from the low noise amplifiers 30 through pre-amplifiers 42 to receive splitters 40. These are n-way splitters where n depends upon the number of fixed and floating transceivers allocated to a sector. One path from each receive splitter 40 in a receive splitter module 44 is connected to one of the receive input ports 52, 54, 56, 58 of the multiple diverse receiver. This connection will be direct for fixed transceivers or via a 3-way switch 46 (one for each facet or sector) for floating transceivers.

The key features of the invention can now be considered in more detail and contrasted with the conventional sectorised base station. The positioning of a power level sensor prior to the diplexer in the antenna allows the radiated power to be monitored. The level is digitised before being sent to the relevant transceiver. The output level from the BTS cabin can then be adjusted to enable a constant maximum power level to be radiated from the antenna. Typically, standards require that power levels are not altered during a time-slot; for a measurement which takes place during one time-slot, the level is not altered by reason of the feedback until the next time slot for that particular signal transmission occurs. Monitoring the power at the masthead allows the level to be set independently of installation site configurations such as mast height and cable length. It also means that the system can tolerate fluctuations due to temperature, loading, component tolerances, etc. without losing peak output power.

The gain of the transmit path is controlled in a number of frequency sub-bands. All the frequencies are divided into these sub-bands and when the base station signals that it is about to change frequency say onto frequency "F1", a reference table is consulted for the gain parameters associated with frequency F1 and the input level to the transmit amplifiers is adjusted by varying the attenuation of the variable attenuator. By doing this the output power does not "dip" when a frequency hop is made. Normally the amplifier would have a gain which is frequency-dependent and so by adjusting the attenuation/gain according to frequency, a pre-set power level is maintained at the output of the amplifier for the installation.

Without frequency-dependent gain control it would be possible for the output power to reduce at certain frequencies, thereby reducing the range of the installation. If there was only one control setting for the amplifier, the gain control loop of the amplifier will always be set irrespective of frequency at this point, so at some points it will be above and at some points it would be below the desired output gain of the amplifier. So by dividing the frequency band up and controlling it more carefully in the sub-bands, when the base station frequency hops the first thing the controller does is inform the receiver that it is going to hop to frequency F10. It consults the reference table for parameter to be used for F10, to thereby obtain a suitable response from the amplifier and thus good constant RF coverage.

The use of floating transceivers to be shared between sectors in conventional base stations requires the use of high power switches with the attendant problems of isolation, power loss, intermodulation products, etc. The positioning of the switches in this invention prior to the main amplification and prior to the level detection allows low power switches to be used and the inherent power loss associated with the switches to be compensated for.

It is to be noted that the power level sensor can control the antenna power output dynamically; when a mobile is in close vicinity to the base station there is no need for a maximum output to be directed at such a mobile. In fact this feature is part of transmission protocols, such as in the GSM protocol.

## Claims

**1.** A cellular radio base station comprising a plurality of r.f. transceivers (60,61) each for transmitting and receiving r.f. signals to and from an antenna array (20,22,24) via respective transmit and receive paths for one or more calls, wherein each array comprises individual transmit attenuation means (82) and amplifying means (80) for each call, power detecting means (70) located proximate to the antenna (28), and digital feedback means (32) for controlling the attenuation means responsive to the detected output power.

**2.** A base station arrangement according to claim 1, operable on a frequency hopping basis with the frequency band divided into a number of sub-bands, wherein the amplifiers (80) of the base station amplify the output as a function of frequency sub-band.

**3.** An antenna arrangement according to claim 1 or 2 wherein the attenuation is varied as a function of frequency.

**4.** In a cellular radio base station comprising a plurality of r.f. transceivers (60,61) each for transmitting and receiving r.f. signals to and from an antenna array (20,22,24) via respective transmit and receive paths for one or more calls, wherein each array comprises individual transmit attenuation means (82) and amplifying means (80) for each call, power detecting means (70) located proximate to the antenna (28), and digital feedback means (32) for controlling the attenuation means responsive to the detected output power, a method of operating a cellular radio base station comprising the steps of:
transmitting radio signals at a particular radio frequency for each call;
monitoring the output power of the signal via the power level sensing means; and
varying the power level fed to the antenna responsive to the power level sensing means.

**5.** A method according to claim 4 wherein the frequency band is divided into sub-bands and the signals provided to the amplifiers are attenuated by a given factor dependent upon the frequency sub-band of operation.

**6.** In a frequency hopping base station arrangement, a method of operation comprising the steps of:
i) transmitting a radio signal at a particular frequency by a transmitter operable to feed an antenna,
ii) monitoring the output power level of the signal via power level sensing means;
iii) transmitting data digitally from the power level sensing means to transmitter control means;
iv) varying the power level fed to the antenna (28) responsive to the power level sensing means; and
v) changing the operating frequency of the call and monitoring the output power level as in steps ii) through to iv) until the frequency is changed and the process is repeated.

**7)** A method according to claim 6 further comprising the step of dividing the frequency operating band of the base station into a number of frequency sub-bands and varying the power level fed to the amplification means (80, 34) responsive to frequency sub-band.
